# EUROPÄISCHE PATENTSCHRIFT

(11) **EP 2 824 220 B1**
(45) Veröffentlichungstag und Bekanntmachung des Hinweises auf die Patenterteilung: **20.11.2019**
(21) Anmeldenummer: 14176110.6
(22) Anmeldetag: 08.07.2014
(51) Int. Cl.: C23C 4/02, C23C 14/08, C25D 13/02, C23C 18/12, C23C 4/00, C23C 4/18, C23C 28/04, C23C 28/00, C23C 4/11

(54) **CMAS-inerte Wärmedämmschicht und Verfahren zur ihrer Herstellung**
CMAS-inert thermal insulation layer and method for its production
Couche d'isolation thermique CMAS-INERTE et son procédé de fabrication

(30) Priorität: 12.07.2013 DE 102013213742
(43) Veröffentlichungstag der Anmeldung: 14.01.2015
(73) Patentinhaber: MTU Aero Engines AG, 80995 München (DE)
(72) Erfinder: Döbber, Philipp, 30161 Hannover (DE); Dr. Bamberg, Joachim, 85221 Dachau (DE); Schneiderbanger, Stefan, 85221 Dachau (DE); Bautsch, Thomas, 30657 Hannover (DE)
(74) Vertreter: Lang, Christian

(56) Entgegenhaltungen:
- EP-A1- 1 609 885
- EP-A1- 2 053 141
- EP-A2- 1 225 251
- WO-A1-2007/017488
- US-A1- 2005 013 994
- US-A1- 2006 068 189
- US-A1- 2010 136 349
- US-A1- 2011 151 132
- US-B1- 6 827 969

## Beschreibung

### HINTERGRUND DER ERFINDUNG

### GEBIET DER ERFINDUNG

Die vorliegende Erfindung betrifft ein Verfahren zur Herstellung einer Wärmedämmschicht für ein metallisches Bauteil sowie eine entsprechende Wärmedämmschicht für ein metallisches Bauteil

### STAND DER TECHNIK

Strömungsmaschinen, wie stationäre Gasturbinen und Flugtriebwerke, werden zur Steigerung der Effizienz bei immer höheren Temperaturen betrieben, so dass Bauteile im mit Heißgas beaufschlagten Bereich der Brennkammer und der Hochdruckturbine durch aktive Kühlung und Wärmedämmschichtsysteme (engl.: TBC thermal barrier coating) geschützt werden müssen.

Bekannte Wärmedämmschichtsysteme (WDS) umfassen eine metallische Haft- und/oder Oxidationsschutzschicht auf Basis von MCrAIY, wobei M für ein Metall wie Nickel, Kobalt oder Eisen steht. Eine derartige Schicht bietet durch den entsprechenden Chrom- und Aluminiumanteil einen Oxidationsschutz und verbessert die Haftfestigkeit einer im Wärmedämmschichtsystem außen angeordneten Keramikschicht, die üblicherweise aus yttriumstabilisiertem Zirkonoxid (YSZ) besteht.

Obwohl derartige Wärmedämmschichten bereits hervorragende Eigenschaften aufweisen, besteht ein Problem darin, dass Flugtriebwerke enormen Sand- und Staubbelastungen ausgesetzt sein können, wie beispielsweise Aschepartikeln oder industriell induzierten Stäuben. Derartige Sand- und Staubbelastungen werden aufgrund ihrer Zusammensetzung auch als CMAS (Calzium-Magnesium-Aluminium-Silikate) bezeichnet.

Derartige Stäube verflüssigen sich bei hohen Temperaturen und interagieren dann mit der Wärmedämmschicht durch Infiltration von Mikrorissen oder offenen Poren in der äußeren Keramikschicht der Wärmedämmschicht. Dadurch kommt es zu einer Versprödung und einem entsprechenden Versagen der Wärmedämmschicht bzw. insbesondere der Keramikschicht, so dass die durch die Wärmedämmschicht geschützten Bauteile ausgetauscht bzw. repariert werden müssen. Dies führt zu einem erheblichen Aufwand, so dass ein Schutz der Wärmedämmschichten vor Beschädigung durch CMAS erforderlich ist.

Aus dem Stand der Technik sind bereits Maßnahmen zum Schutz der Wärmedämmschichten vor Schädigungen durch CMAS bekannt, wobei durch Anordnung von reaktiven Oxiden oberhalb oder im äußeren Bereich der Keramikschicht der Wärmedämmschicht ein Schutz dadurch bewirkt werden soll, dass durch Reaktion des verflüssigten CMAS mit den reaktiven Oxiden eine stabile kristalline Schicht auf der Wärmedämmschicht gebildet werden soll, die vor einem weiteren Angriff durch CMAS schützt. Beispiele für derartige Schutzmaßnahmen sind beispielsweise in der US 2004/0170849 A1, der EP 1 428 902 A1, der US 5,660,885 A, der US 7,780,832 B2, der EP 0 783 043 A1, der US 5,338,577 A, der US 7,833,586 B2 und in Julie M. Drexler et al., Air-Plasma-sprayed thermal barrier coatings that are resistant to hightemperature attack by glassy deposits, Acta Materialia 58 (2010) 6835 bis 6844 genannt.

In der zuletzt genannten Veröffentlichung wird vorgeschlagen, neben Aluminium auch Titan in fester Lösung in yttriumstabilisiertem Zirkonoxid vorzusehen, wobei entsprechende Keramikschichten durch atmosphärisches Plasmaspritzen (APS) oder Suspensionsplasmaspritzen (SPS) erzeugt werden. Durch die Aufnahme von Aluminium und Titan in die CMAS-Glasschmelze soll eine Kristallisation bewirkt werden, so dass die Glasschmelze nicht mehr in die Wärmedämmschicht eindringen kann. Allerdings liegt das Aluminium und Titan in fester Lösung in der ZrO₂ - Keramik der Keramikschicht vor, so dass zunächst durch die CMAS-Glasschmelze das Aluminium und Titan aus der Keramikschicht der Wärmedämmschicht aufgenommen werden muss. Dies ist jedoch für eine effiziente Bereitstellung einer Schutzwirkung gegenüber CMAS-Schmelzen nachteilig.

Das Dokument US 2006/0068189 A1 offenbart ein Verfahren zur Herstellung einer stabilisierten, plasmagespritzten Wärmedämmschicht, bei welchem eine poröse Wärmedämmschicht in einem Sol - Gel - Verfahren behandelt wird, sodass Metalloxidpartikel in den Poren der porösen Wärmedämmschicht erzeugt werden.

Die Druckschrift US 2010/0136349 A1 offenbart eine mehrlagige Wärmedämmschicht, bei der eine eine CMAS - Degradation verhindernde Deckschicht aus Oxiden von seltenen Erden Aluminiumoxid, Siliziumoxid, Silikaten von seltenen Erden, Titanoxid, Alkalimetalloxiden oder Alkalierdmetalloxiden gebildet ist.

### OFFENBARUNG DER ERFINDUNG

### AUFGABE DER ERFINDUNG

Es ist deshalb Aufgabe der vorliegenden Erfindung, eine Wärmedämmschicht und ein Verfahren zu ihrer Herstellung bereitzustellen, die effektiv Schutz gegen CMAS-Schmelzen bietet, wobei die Herstellung einer entsprechenden Wärmedämmschicht einfach gehalten werden soll.

### TECHNISCHE LÖSUNG

Diese Aufgabe wird gelöst durch ein Verfahren zur Herstellung einer Wärmedämmschicht mit den Merkmalen des Anspruchs 1 sowie durch eine Wärmedämmschicht mit den Merkmalen des Anspruchs 12. Vorteilhafte Ausgestaltungen sind Gegenstand der abhängigen Ansprüche.

Die Erfindung geht aus von der Idee, dass neben Aluminiumoxid als reaktivem Oxid zur Reaktion mit CMAS-Schmelzen zusätzlich Titanoxid bereitgestellt werden soll, um die Schutzwirkung durch Reaktion mit der CMAS-Schmelze und Ausbildung einer kristallinen Oberflächenschicht zu verbessern. Anstelle der im Stand der Technik vorgeschlagenen Lösung zur Bereitstellung von Titan in der gesamten Keramikschicht der Wärmedämmschicht wird jedoch die Bereitstellung von Titan und die Ausbildung von Titanoxidpartikeln im Oberflächenbereich und insbesondere an Grenzflächen innerhalb der Keramikschicht der Wärmedämmschicht vorgeschlagen, so dass das Titan bzw. die Titanoxid - Partikel oder - Körner zielgenau an den Stellen zur Verfügung stehen, an denen sie auch gebraucht werden. Die Erzeugung von Aluminiumoxid und Titanoxid im oberflächennahen Bereich der Keramikschicht einer Wärmedämmschicht kann durch Infiltrieren von Aluminium - und Titan - haltigen Partikeln oder Stoffen oder durch physikalische Dampfphasenabscheidung von Aluminiumoxid und Titanoxid in der Keramikschicht erfolgen.

Durch die Infiltration von Aluminium - und Titan - haltigen Partikeln oder Stoffen können das Aluminium und das Titan genau in den Oberflächenbereichen zur Verfügung gestellt werden, in denen sie für die Reaktion mit den CMAS-Schmelzen benötigt werden. Außerdem ist eine einfache Erzeugung von Aluminiumoxid - und Titanoxidpartikeln möglich.

Gleiches gilt für die Abscheidung von Aluminiumoxid und Titanoxid durch physikalische Dampfphasenabscheidung im äußeren Randbereich der Keramikschicht, da bei der physikalischen Dampfphasenabscheidung in einfacher Weise eine Variation der chemischen Zusammensetzung im Oberflächenschichtbereich durchführbar ist, so dass lediglich im Oberflächenbereich Titanoxid in Verbindung mit Aluminiumoxid in der Keramikschicht zusätzlich abgeschieden wird, während in tieferen, zum Grundwerkstoff hin angeordneten Bereichen eine Keramikschicht ohne Zusätze, wie z.B. eine reine yttriumstabilisierte Zirkonoxidschicht abgeschieden werden kann.

Die Infiltrationsmethode eignet sich besonders für Keramikschichten mit einer raueren Oberfläche, wie beispielsweise Keramikschichten, die durch Plasmaspritzen, insbesondere atmosphärisches Plasmaspritzen erzeugt werden, während die Einbringung von Aluminium und Titan bzw. deren Oxide mittels physikalischer Dampfphasenabscheidung bevorzugt bei der Herstellung glatter Keramikschichten eingesetzt werden kann.

Folglich wird nach einem ersten Aspekt der Erfindung, für den selbstständig und in Kombination mit anderen Aspekten der Erfindung Schutz begehrt wird, ein Verfahren zur Ausbildung einer Wärmedämmschicht für ein metallisches Bauteil beansprucht, bei welchem eine Keramikschicht, insbesondere durch thermisches Spritzen, ausgebildet wird, in der zumindest teilweise Aluminiumoxid und Titanoxid angeordnet sind, wobei das Aluminiumoxid und das Titanoxid durch Infiltrieren von Aluminium - und Titan - haltigen Partikeln oder Stoffen oder durch physikalische Dampfphasenabscheidung eingebracht werden.

Bei der Infiltration werden Aluminiumoxid - und Titanoxid - Partikel oder Aluminium und Titan enthaltende Partikel als Nanopartikel mit einer mittleren oder maximalen Korngröße von bis zu 200 nm, insbesondere bis zu 50 nm, vorzugsweise im Bereich von 15 bis 30 nm verwendet.

Die Infiltration kann durch Aufbringen einer Suspension, die Aluminiumoxid - und Titanoxid - Partikel oder Aluminium und Titan enthaltende Partikel aufweist, auf die Keramikschicht oder durch Eintauchen der Keramikschicht in eine derartige Suspension erfolgen. Außerdem können Sol - Gel - Verfahren eingesetzt werden. Eine weitere Möglichkeit besteht darin durch Elektrophorese oder Elektrolyse von Aluminium - und Titan - haltigen Stoffen eine Abscheidung von Aluminium - und Titan - haltigen Partikeln zu bewirken, die durch anschließende Behandlung in Aluminiumoxid - und Titan - Partikel umgewandelt werden können.

Die Aluminiumoxid - und Titanoxid - Partikel und/oder die Aluminium - und Titan - haltigen Stoffe können in einer wässrigen oder alkoholischen Suspension enthalten sein.

Bei der Infiltration kann die Keramikschicht 0,25 bis 30 Stunden, vorzugsweise 0,5 bis 20 Stunden, in die Suspension eingetaucht und anschließend bis zu zwei Stunden, vorzugsweise bis zu einer Stunde, bei einer Temperatur von bis zu 500°C, insbesondere bis zu 250°C, vorzugsweise bis zu 200°C, getrocknet werden, wobei auch eine Oxidation der eingebrachten Partikel stattfinden kann.

Die Aluminium - haltigen Ausgangsstoffe für eine Infiltration können Aluminium - Alkoxide, Aluminium - β - Diketone, Aluminiumalkyle, Aluminium - Sole, Aluminiummethoxide, Aluminiumpropoxide, Aluminiumisopropoxide, Aluminiumbutoxide, Aluminium - sec - Butoxide, Aluminium - tri - Butoxide Aluminium - haltige metallorganische Verbindungen umfassen, während die Titan - haltigen Ausgangsstoffe auf Basis metallorganischer Lösungen bereitgestellt werden können.

Die Keramikschicht kann einmal oder mehrfach, vorzugsweise bis zu viermal, für jeweils bis zu zwei Stunden, vorzugsweise bis zu einer Stunde, insbesondere bis zu 30 Minuten, infiltriert werden und anschließend bei Temperaturen von 200°C bis 800°C, vorzugsweise 300°C bis 600°C, insbesondere um 400°C, für 0,5 Stunden bis 2 Stunden, vorzugsweise eine Stunde, und anschließend bei 600°C bis 1000°C, vorzugsweise bei 700°C bis 900°C, insbesondere bei 800°C, für ein bis vier Stunden, vorzugsweise 1,5 bis drei Stunden, insbesondere zwei Stunden ausgelagert werden.

Das Aluminiumoxid und das Titandioxid werden nur in den äußeren Bereich der Keramikschicht eingebracht. Dies gilt insbesondere auch für die Herstellung der Wärmedämmschicht bzw. insbesondere der Keramikschicht der Wärmedämmschicht über physikalische Dampfphasenabscheidung.

Entsprechend umfasst die Keramikschicht mindestens zwei Teilschichten, und zwar eine Teilschicht ohne Aluminiumoxid und Titanoxid, und eine Teilschicht mit Aluminiumoxid und Titanoxid, wobei der Übergang von einer Teilschicht zur anderen Teilschicht kontinuierlich oder diskontinuierlich erfolgen kann, indem entweder kontinuierlich während der Abscheidung das abgeschiedene Material verändert wird oder indem nach dem Abscheiden einer ersten Teilschicht der Keramikschicht eine zweite Teilschicht mit veränderter Zusammensetzung abgeschieden wird. Der Vorteil der physikalischen Dampfphasenabscheidung ist somit die einfache Herstellung, da das Aluminiumoxid und das Titanoxid gleichzeitig mit der Abscheidung der Keramikschicht abgeschieden werden können.

Die physikalische Dampfphasenabscheidung kann die Abscheidung durch Elektronenstrahl - oder Laserstrahlverdampfung oder durch Sputtern umfassen.

Die Herstellung einer zweilagigen Keramikschicht mit sich kontinuierlich verändernder Zusammensetzung kann durch Verwendung eines Ausgangsmaterials mit örtlich unterschiedlicher Zusammensetzung verwirklicht werden. Durch Verdampfen des unterschiedlich zusammengesetztem Material in der zeitlichen Abfolge kann in einfacher Weise eine zweilagige Schicht mit dazwischen angeordneter Gradientenschicht für den kontinuierlichen Übergang erzeugt werden.

Als Keramikschicht wird yttrium -, yttriumoxid -, calcium - oder magnesiumstabilisiertes Zirkonoxid gewählt.

Nach einem weiteren Aspekt der Erfindung, für den selbstständig und in Kombination mit anderen Aspekten der Erfindung Schutz begehrt wird, wird eine Wärmedämmschicht für ein metallisches Bauteil beansprucht, wobei die Wärmedämmschicht eine Keramikschicht umfasst, in welcher im äußeren Deckschichtbereich Aluminiumoxid und Titanoxid angeordnet sind.

Aluminiumoxid und Titanoxid können auch an Grenzflächen innerhalb der Schicht vorliegen, wobei als Grenzflächen insbesondere Rissflanken, Korngrenzen Oberflächen von Poren in Frage kommen.

Aluminiumoxid und Titanoxid liegen im Deckschichtbereich mit einem Anteil von bis zu 30 Gew.-% Aluminium, vorzugsweise bis zu 20 Gew.-% Aluminium, und einem Anteil von bis zu 10 Gew.-% Titanoxid, insbesondere 5 Gew.-% Titanoxid vor.

### KURZBESCHREIBUNG DER ZEICHNUNGEN

Die beigefügten Zeichnungen zeigen in rein schematischer Weise in
- Fig. 1: eine Querschnittansicht durch eine erste Ausführungsform einer edindungsgemäßen Wärmedämmschicht;
- Fig. 2: eine Querschnittansicht durch eine zweite Ausfuhrungsform einer erfindungsgemäßen Wärmedämmschicht; und in
- Fig. 3: eine schematische Darstellung einer Apparatur zur Herstellung einer erfindungsgemäßen Wärmedämmschicht.

### AUSFÜHRUNGSBEISPIELE

Weitere Vorteile, Kennzeichen und Merkmale der vorliegenden Erfindung werden bei der nachfolgenden detaillierten Beschreibung von Ausführungsbeispielen anhand der beigefügten Zeichnungen deutlich. Allerdings ist die Erfindung nicht auf diese Ausführungsbeispiele beschränkt.

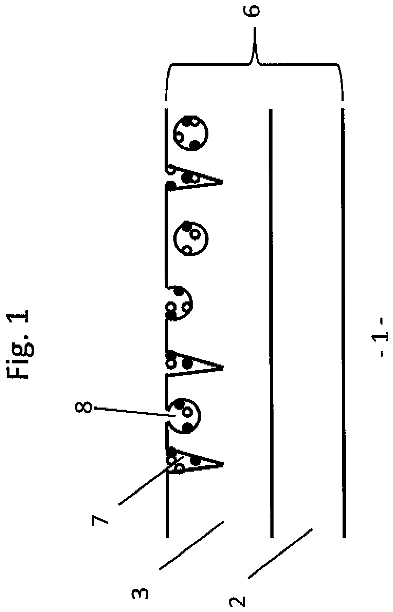

Die Fig. 1 zeigt einen Querschnitt durch eine erfindungsgemäße Wärmedämmschicht auf einem Substrat 1.

Das Substrat 1 kann ein beliebiger metallischer Gegenstand, wie beispielsweise eine Turbinenschaufel oder eine Brennkammer eines Flugtriebwerks sein.

Die Wärmedämmschicht 6 umfasst eine metallische Haft - und/oder Oxidationsschutzschicht 2, die beispielsweise durch eine sogenannte MCrAlY-Schicht gebildet sein kann, wobei M für ein Metall wie Nickel, Kobalt oder Eisen steht und neben einer verbesserten Haftung der nachfolgenden Keramikschicht 3 auf dem Substrat 1 auch für einen Oxidationsschutz des Substrats 1 sorgt. Entsprechend können die Bestandteile Chrom und Aluminium sowie Yttrium in einer geeigneten Größenordnung gewählt werden, um die gewünschten Eigenschaften zu erzielen.

Neben der metallischen Haft - und/oder Oxidationsschutzschicht auf Basis von MCrAlY umfasst die Wärmedämmschicht eine keramische Deckschicht 3, die beispielsweise aus yttriumstabilisiertem Zirkonoxid aufgebaut sein kann, so dass in der Keramikschicht 3 Y₂O₃-Partikel in einer ZrO₂-Matrix eingelagert sein können.

Die Keramikschicht 3 weist üblicherweise Mikrorisse 7 oder Poren 8 auf, die in der Darstellung der Fig. 1 rein schematisch etwas überdimensioniert dargestellt sind.

Bei der erfindungsgemäßen Wärmedämmschicht 6 sind in den Mikrorissen 7 und den Poren 8 Aluminiumoxid - und Titanoxid - Partikel infiltriert, die mit Sand- und Aschepartikeln sowie Stäuben, die als CMAS (Calzium - Magnesium - Aluminium - Silikate) bezeichnet werden, eine Reaktionsschicht bilden, so dass sich eine kristalline Phase bildet, die sich hinsichtlich des Schmelzpunkts, der Härte und des thermischen Ausdehnungskoeffizienten ähnlich dem yttriumstabilisierten Zirkonoxid verhält. Dadurch wird verhindert, dass schmelzflüssiges CMAS in die Wärmedämmschicht eindringen und zu einer Zerstörung der Wärmedämmschicht führen kann.

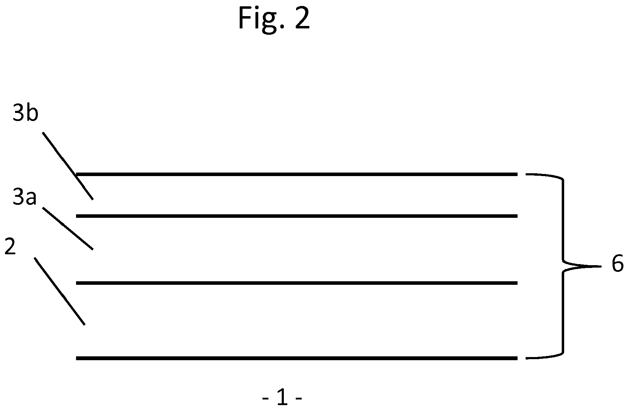

Die Fig. 2 zeigt eine weitere Ausführungsform einer erfindungsgemäßen Wärmedämmschicht, wobei bei den zu der Ausführungsform der Fig. 1 identischen Bestandteilen gleiche Bezugszeichen verwendet werden. Auf einem metallischen Substrat 1 ist wiederum eine metallische Haft- und/oder Oxidationsschutzschicht 2 in Form einer MCrAlY-Schicht vorgesehen, bei der M wieder für Eisen, Kobalt oder Nickel steht.

Oberhalb der metallischen Haft- und/oder Oxidationsschutzschicht 2 ist, wie im Ausführungsbeispiel der Fig. 1, eine Keramikschicht aus beispielsweise yttriumstabilisiertem Zir, kondioxid aufgebracht. Allerdings ist die Keramikschicht 3 zweiteilig ausgebildet mit einer Teilschicht 3a, die aus dem im Wesentlichen reinen yttriumstabiliserten Zirkonoxid ohne nennenswerte weitere Bestandteile gebildet ist, während in der äußeren Teilschicht 3b Aluminiumoxid - und Titanoxidpartikel eingelagert sind. Bei dem Ausfuhrungsbeispiel der Fig. 2 ist die Keramikschicht 3 durch ein PVD - (physical vapor deposition (physikalische Dampfphasenabscheidung)) - Verfahren aufgebracht, wobei lediglich die äußere Teilschicht 3b mit einer veränderten chemischen Zusammensetzung abgeschieden ist.

Bei der Aufbringung der Keramikschicht 3 mittels PVD - Verfahren können beispielsweise Verfahren wie Elektronenstrahlverdampfen oder Laserstrahlverdampfen eingesetzt werden. Um eine unterschiedliche chemische Zusammensetzung in den Teilschichten 3a und 3b zu erzielen, muss lediglich das Ausgangsmaterial entsprechend unterschiedlich gewählt werden. Dies kann einerseits durch einen Wechsel des entsprechenden Ausgangsmaterials verwirklicht werden oder durch die Verwendung eines Ausgangsmaterials mit örtlich unterschiedlicher Zusammensetzung und einem Aufschmelzen und Verdampfen des Ausgangsmaterials mittels des Elektronen- oder Laserstrahls in unterschiedlichen Bereichen des Ausgangsmaterials.

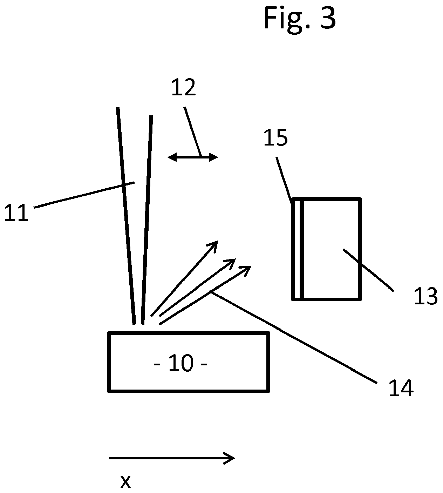

Die Fig. 3 zeigt in einer schematischen Darstellung eine Apparatur, mit der eine Wärmedämmschicht gemäß Fig. 2 hergestellt werden kann.

Die Fig. 3 zeigt das Ausgangsmaterial 10, welches auch als Target bezeichnet wird, und einen Elektronen- oder Laserstrahl 11, mit dem das Ausgangsmaterial 10 aufgeschmolzen wird, so dass das Material entsprechend der Darstellung der Pfeile 14 verdampft und sich als Oberflächenschicht 15 auf einem zu beschichtenden Bauteils 13 wieder niederschlägt. Durch die Verfahrbarkeit des Laser- oder Elektronenstrahls 11, welche durch den Doppelpfeil 12 angedeutet ist, kann das Aufschmelzen und Verdampfen des Ausgangsmaterials an unterschiedlichen Stellen des Ausgangsmaterials stattfinden, so dass bei einer sich örtlich ändernden chemischen Zusammensetzung des Ausgangsmaterials unterschiedliches Material verdampft und in der Oberflächenschicht 15 auf dem zu beschichtenden Bauteil abgeschieden wird. Ändert sich beispielsweise die chemische Zusammensetzung des Ausgangsmaterials 10 kontinuierlich entlang der X-Richtung, so kann bei einer Bewegung des Elektronen- oder Laserstrahls 11 entlang der X-Richtung Material mit unterschiedlicher Zusammensetzung verdampft werden, so dass eine kontinuierlich sich in ihrer Zusammensetzung ändernde Schicht 15 auf den Bauteil 13 abgeschieden wird. Entsprechend kann eine Gradientenschicht als Keramikschicht 6 gebildet werden, bei der kontinuierlich die Zusammensetzung von einer reinen Zirkondioxid - und Yttriumoxid - Schicht in eine mit Aluminiumoxid und Titanoxid angereicherte yttriumstabilisierte Zirkonoxidschicht verändert wird.

Obwohl die vorliegende Erfindung anhand der Ausführungsbeispiele detailliert beschrieben worden ist, ist die Erfindung nicht auf diese Ausführungsbeispiele beschränkt, sondern vielmehr sind Abwandlungen in der Weise möglich, dass einzelne Merkmale weggelassen oder andersartige Kombinationen von Merkmalen verwirklicht werden, ohne dass der Schutzbereich der beigefügten Ansprüche verlassen wird. Die vorliegende Offenbarung schließt sämtliche Kombinationen aller vorgestellter Einzelmerkmale mit ein.

## Patentansprüche

1. Verfahren zur Ausbildung einer Wärmedämmschicht (6) für ein metallisches Bauteil (1, 13), bei welchem eine Keramikschicht (3) ausgebildet wird, wobei als Keramikschicht yttrium -, yttriumoxid -, calcium - oder magnesiumstabilisiertes Zirkonoxid abgeschieden wird,
**dadurch gekennzeichnet, dass**
teilweise Aluminiumoxid und Titanoxid in der Keramikschicht angeordnet werden, wobei
das Aluminiumoxid und das Titanoxid durch Infiltrieren von Aluminium - und Titan - haltigen Partikeln oder Stoffen nur im äußeren Bereich der Keramikschicht (3) in die Keramikschicht eingebracht werden, wobei bei der Infiltration die Aluminiumoxid - und die Titanoxid - Partikel oder die Aluminium - und Titan - enthaltenden Partikel oder Stoffe als Nanopartikel mit einer mittleren Korngröße oder maximalen Größe von bis zu 200 nm verwendet werden,
oder
das Aluminiumoxid und das Titanoxid durch physikalisches Dampfphasenabscheiden nur im äußeren Bereich der Keramikschicht (3) eingebracht werden.

2. Verfahren nach Anspruch 1,
**dadurch gekennzeichnet, dass**
bei der Infiltration die Aluminiumoxid - und die Titanoxid - Partikel oder die Aluminium - und Titan - enthaltenden Partikel oder Stoffe als Nanopartikel mit einer mittleren Korngröße oder maximalen Größe von bis zu 50 nm, vorzugsweise im Bereich von 15 bis 30 nm, verwendet werden.

3. Verfahren nach einem der vorhergehenden Ansprüche,
**dadurch gekennzeichnet, dass**
die Infiltration durch Aufbringen oder Eintauchen in eine Suspension oder durch ein Sol - Gel - Verfahren oder durch Elektrophorese oder Elektrolyse durchgeführt wird.

4. Verfahren nach einem der vorhergehenden Ansprüche,
**dadurch gekennzeichnet, dass**
die Aluminiumoxid - und Titanoxidpartikel und/oder die Aluminium - und Titan - haltigen Partikel oder Stoffe in einer wässrigen oder alkoholischen Suspension enthalten sind.

5. Verfahren nach einem der vorhergehenden Ansprüche,
**dadurch gekennzeichnet, dass**
die Keramikschicht 0,25 bis 30 Stunden, vorzugsweise 0,5 bis 20 Stunden, in die Suspension eingetaucht und anschließend bis zu zwei Stunden, vorzugsweise bis zu einer Stunde, bei einer Temperatur bis zu 500°C, insbesondere bis zu 250°C, vorzugsweise bis zu 200°C, getrocknet wird.

6. Verfahren nach einem der vorhergehenden Ansprüche,
**dadurch gekennzeichnet, dass**
die Aluminium - haltigen Ausgangsstoffe mindestens eine Komponente aus der Gruppe aufweisen, die Aluminium - Alkoxide, Aluminium - β - Diketone, Aluminiumalkyle, Aluminium - Sole, Aluminiummethoxide, Aluminiumpropoxide, Aluminiumisopropoxide, Aluminiumbutoxide, Aluminium - sec - Butoxide, Aluminium - tri - Butoxide und Aluminium - haltige metallonganische Lösungen umfasst und/oder dass die Titan - haltigen Ausgangsstoffe durch Titan - haltige metallorganische Lösungen gebildet werden.

7. Verfahren nach einem der Ansprüche 1 bis 4 oder 6,
**dadurch gekennzeichnet, dass**
die Keramikschicht (3) einmal oder mehrfach für jeweils bis zu zwei Stunden infiltriert wird und anschließend bei Temperaturen von 200°C bis 800°C für 0,5 Stunden bis 2 Stunden und anschließend bei 600°C bis 1000°C für eine bis vier Stunden ausgelagert wird.

8. Verfahren nach Anspruch 1,
**dadurch gekennzeichnet, dass**
das Aluminiumoxid und das Titanoxid zur Ausbildung einer Teilschicht (3b) der Keramikschicht (3) gleichzeitig mit der Abscheidung der Keramikschicht (3) abgeschieden werden.

9. Verfahren nach einem der Ansprüche 1 oder 8,
**dadurch gekennzeichnet, dass**
die Keramikschicht (3) mindestens zwei Teilschichten (3a, 3b) umfasst, und zwar eine Teilschicht ohne Aluminiumoxid und Titanoxid, und eine Teilschicht (3b) mit Aluminiumoxid und Titanoxid, wobei der Übergang von einer Teilschicht zur anderen Teilschicht kontinuierlich oder diskontinuierlich erfolgt, indem entweder kontinuierlich während der Abscheidung das abgeschiedene Material verändert wird oder indem nach Abscheiden einer ersten Teilschicht (3a) der Keramikschicht (3) eine zweite Teilschicht (3b) mit veränderter Zusammensetzung abgeschieden wird.

10. Verfahren nach einem der Ansprüche 1 oder 8 bis 9,
**dadurch gekennzeichnet, dass**
die Abscheidung durch Elektronenstrahl oder Laserstrahlverdampfung oder durch Sputtern erfolgt.

11. Verfahren nach Anspruch 9 oder 10,
**dadurch gekennzeichnet, dass**
mittels physikalischer Dampfphasenabscheidung bei der Abscheidung der Keramikschicht (3) ein Material mit örtlich unterschiedlicher Zusammensetzung verdampft wird.

12. Wärmedämmschicht für ein metallisches Bauteil, wobei die Wärmedämmschicht eine außen als Deckschicht angeordnete Keramikschicht (3) aus yttrium -, yttriumoxid -, calcium - oder magnesiumstabilisiertem Zirkonoxid umfasst,
**dadurch gekennzeichnet, dass**
die Keramikschicht (3) teilweise Aluminiumoxid und Titanoxid umfasst, sodass sie zwei benachbarte Teilschichten umfasst, und zwar eine Teilschicht ohne Aluminiumoxid und Titanoxid und eine Teilschicht im oberflächennahen, äußeren Randbereich der Keramikschicht mit Aluminiumoxid und Titanoxid, sodass das Aluminiumoxid und Titanoxid nur im äußeren Deckschichtbereich der Keramikschicht angeordnet sind, wobei das Aluminiumoxid und Titanoxid im Deckschichtbereich mit einem Anteil von bis zu 30 Gew.-% Aluminium und einem Anteil von bis zu 10 Gew.-% Titanoxid vorliegen.

13. Wärmedämmschicht nach Anspruch 12,
**dadurch gekennzeichnet, dass**
das Aluminiumoxid und Titanoxid im Deckschichtbereich mit einem Anteil von bis zu 20 Gew.-% Aluminium, und einem Anteil von 5 Gew.-% Titanoxid, vorliegt.

## Claims

1. Method for forming a thermal insulation layer (6) for a metallic component (1, 13) which involves formation of a ceramic layer (3) wherein, yttrium-stabilised, yttrium oxide-stabilised, calcium-stabilised or magnesium-stabilised zirconium oxide is deposited as the ceramic layer,
**characterised in that**
aluminium oxide and titanium oxide are partially disposed in the ceramic layer, wherein the aluminium oxide and the titanium oxide are incorporated in the outer region of the ceramic layer (3) only, by infiltrating particles or substances containing aluminium and titanium, wherein,
during the infiltration, the aluminium oxide and titanium oxide particles or the particles or substances containing aluminium and titanium are used as nanoparticles having an average particle size or maximum size of up to 200 nm,
or
the aluminium oxide and the titanium oxide are introduced by physical vapour deposition in the outer region of the ceramic layer (3) only.

2. Method according to claim 1,
**characterised in that**
during the infiltration, the aluminium oxide and titanium oxide particles or the particles or substances containing aluminium and titanium are used as nanoparticles having an average particle size or a maximum size of up to 50 nm, preferably in the range of 15 to 30 nm.

3. Method according to any of the preceding claims,
**characterised in that**
the infiltration is carried out by application or immersion in a suspension or by a sol-gel process or by electrophoresis or electrolysis.

4. Method according to any of the preceding claims,
**characterised in that**
the aluminium oxide and titanium oxide particles and/or the particles or substances containing aluminium and titanium are contained in an aqueous or alcoholic suspension.

5. Method according to any of the preceding claims,
**characterised in that**
the ceramic layer is immersed in the suspension for 0.25 to 30 hours, preferably 0.5 to 20 hours, and then dried for up to two hours, preferably up to one hour, at a temperature of up to 500°C, in particular up to 250°C, preferably up to 200°C.

6. Method according to any of the preceding claims,
**characterised in that**
the aluminium-containing starting materials have at least one component from the group which comprises aluminium alkoxides, aluminium β-diketones, aluminium alkyls, aluminium sols, aluminium methoxides, aluminium propoxides, aluminium isopropoxides, aluminium butoxides, aluminium sec-butoxides, aluminium tributoxides and aluminium-containing organometallic solutions and/or **in that** the titanium-containing starting materials are formed by titanium-containing organometallic solutions.

7. Method according to any of claims 1 to 4 or 6,
**characterised in that**
the ceramic layer (3) is infiltrated once or several times for up to two hours in each case and then conditioned at temperatures of 200°C to 800°C for 0.5 hours to 2 hours and then at 600°C to 1000°C for one to four hours.

8. Method according to claim 1,
**characterised in that**
the aluminium oxide and the titanium oxide for the purpose of forming a partial layer (3b) of the ceramic layer (3) are deposited simultaneously with the deposition of the ceramic layer (3).

9. Method according to any of claims 1 or 8,
**characterised in that**
the ceramic layer (3) comprises at least two partial layers (3a, 3b), more precisely a partial layer without aluminium oxide and titanium oxide, and a partial layer (3b) with aluminium oxide and titanium oxide, wherein the transition from one partial layer to the other partial layer occurs continuously or discontinuously, either by continuously altering the deposited material during the deposition or by depositing a second partial layer (3b) of altered composition after deposition of a first partial layer (3a) of the ceramic layer (3).

10. Method according to any of claims 1 or 8 to 9,
**characterised in that**
the deposition proceeds by electron beam or laser beam evaporation or by sputtering.

11. Method according to claim 9 or 10,
**characterised in that**
by means of physical vapour phase deposition during deposition of the ceramic layer (3), a material of locally different composition is evaporated.

12. Thermal insulation layer for a metallic component, wherein the thermal barrier layer comprises a ceramic layer (3) disposed on the outside as a top layer consisting of yttrium-stabilised, yttrium oxide-stabilised, calcium oxide-stabilised or magnesium-stabilised zirconium oxide,
**characterised in that**
the ceramic layer (3) partially comprises aluminium oxide and titanium oxide such that it comprises two adjacent partial layers, more precisely a partial layer without aluminium oxide and titanium oxide and a partial layer with aluminium oxide and titanium oxide in the near-surface outer edge area of the ceramic layer such that the aluminium oxide and titanium oxide are disposed in the outer top layer region of the ceramic layer only, wherein the aluminium oxide and titanium oxide are present in the top layer region in a proportion of up to 30% by weight aluminium and a proportion of up to 10% by weight titanium oxide.

13. Thermal insulation layer according to claim 12,
**characterised in that**
the aluminium oxide and titanium oxide are present in the top layer region in a proportion of up to 20% by weight aluminium and in a proportion of 5% by weight titanium oxide.

## Revendications

1. Procédé de formation d'une couche calorifuge (6) pour un composant métallique (1, 13), dans lequel est formée une couche de céramique (3), dans lequel on dépose comme couche de céramique de l'oxyde de zirconium stabilisé à l'yttrium, à l'oxyde d'yttrium, au calcium ou au magnésium,
**caractérisé en ce que**
de l'oxyde d'aluminium et de l'oxyde de titane sont agencés en partie dans la couche de céramique, dans lequel
l'oxyde d'aluminium et l'oxyde de titane sont introduits dans la couche de céramique par infiltration de particules ou de substances contenant de l'aluminium et du titane uniquement dans la zone externe de la couche de céramique (3), dans lequel, lors de l'infiltration, la particule d'oxyde d'aluminium et la particule de titane ou la particule ou la substance contenant de l'aluminium et du titane sont utilisées sous la forme de nanoparticules d'une granulométrie moyenne ou d'une grandeur maximale allant jusqu'à 200 nm,
ou
l'oxyde d'aluminium et l'oxyde de titane sont introduits par dépôt en phase vapeur physique uniquement dans la zone externe de la couche de céramique (3).

2. Procédé selon la revendication 1,
**caractérisé en ce que**,
lors de l'infiltration, la particule d'oxyde d'aluminium et la particule d'oxyde de titane ou la particule ou la substance contenant de l'aluminium et du titane sont utilisées sous la forme de nanoparticules d'une granulométrie moyenne ou d'une grandeur maximale jusqu'à 50 nm, de préférence dans la plage de 15 à 30 nm.

3. Procédé selon l'une quelconque des revendications précédentes,
**caractérisé en ce que**
l'infiltration est réalisée par application ou immersion dans une suspension ou par un procédé de sol-gel ou par électrophorèse ou électrolyse.

4. Procédé selon l'une quelconque des revendications précédentes,
**caractérisé en ce que**
la particule d'oxyde d'aluminium et d'oxyde de titane et/ou la particule ou la substance contenant de l'aluminium et du titane sont contenus dans une suspension aqueuse ou alcoolique.

5. Procédé selon l'une quelconque des revendications précédentes,
**caractérisé en ce que**
la couche de céramique est immergée dans la suspension pendant 0,25 à 30 heures, de préférence 0,5 à 20 heures, et est ensuite séchée jusqu'à deux heures, de préférence jusqu'à une heure, à une température allant jusqu'à 500 °C, en particulier jusqu'à 250°C, de préférence jusqu'à 200 °C.

6. Procédé selon l'une quelconque des revendications précédentes,
**caractérisé en ce que**
les substances de départ contenant de l'aluminium comprennent au moins un composant dans le groupe qui comporte des alcoxydes d'aluminium, de la β-dicétone d'aluminium, de l'alkylaluminium, de la saumure d'aluminium, du méthoxyde d'aluminium, du propoxyde d'aluminium, de l'isopropoxyde d'aluminium, du butoxyde d'aluminium, du sec-butoxyde d'aluminium, du tributoxyde d'aluminium et des solutions organométalliques contenant de l'aluminium et/ou les substances de départ contenant du titane sont formées par des solutions organométalliques contenant du titane.

7. Procédé selon l'une quelconque des revendications 1 à 4 ou 6,
**caractérisé en ce que**
la couche de céramique (3) est infiltrée une ou plusieurs fois jusqu'à respectivement deux heures et est ensuite déposée à des températures de 200 °C à 800 °C pendant 0,5 à 2 heures et ensuite à une température de 600 °C à 1000 °C pendant une à quatre heures.

8. Procédé selon la revendication 1,
**caractérisé en ce que**
l'oxyde d'aluminium et l'oxyde de titane sont déposés pour former une couche partielle (3b) de la couche de céramique (3) simultanément avec le dépôt de la couche de céramique (3).

9. Procédé selon l'une quelconque des revendications 1 ou 8,
**caractérisé en ce que**
la couche de céramique (3) comprend au moins deux couches partielles (3a, 3b), à savoir une couche partielle sans oxyde d'aluminium ni oxyde de titane et une couche partielle (3b) avec de l'oxyde d'aluminium et de l'oxyde de titane, dans lequel la transition d'une couche partielle à l'autre couche partielle se fait de manière contenue ou discontinue en modifiant le matériau déposé en continu au cours du dépôt ou en déposant une seconde couche partielle (3b) de composition modifiée après le dépôt d'une première couche partielle (3a) de la couche de céramique (3).

10. Procédé selon l'une quelconque des revendications 1 ou 8 à 9,
**caractérisé en ce que**
le dépôt se fait par faisceau électronique ou par évaporation au rayon laser ou par pulvérisation.

11. Procédé selon la revendication 9 ou 10,
**caractérisé en ce que**
un matériau de composition localement différente est vaporisé par dépôt en phase vapeur physique lors du dépôt de la couche de céramique (3).

12. Couche calorifuge pour un composant métallique, dans laquelle la couche calorifuge comprend une couche de céramique (3) agencée extérieurement comme couche de finition formée d'oxyde de zirconium stabilisé à l'yttrium, à l'oxyde d'yttrium, au calcium ou au magnésium,
**caractérisée en ce que**
la couche de céramique (3) comprend en partie de l'oxyde d'aluminium et de l'oxyde de titane de sorte qu'elle contienne deux couches partielles voisines, à savoir une couche partielle sans oxyde d'aluminium et oxyde de titane et une couche partielle dans la plage marginale externe proche de la surface de la couche de céramique avec de l'oxyde d'aluminium et de l'oxyde de titane de sorte que l'oxyde d'aluminium et l'oxyde de titane soient agencés uniquement dans la zone de couche de finition externe de la couche céramique, dans laquelle l'oxyde d'aluminium et l'oxyde de titane sont présentes dans la zone de couche de finition avec une fraction allant jusqu'à 30 % en poids d'aluminium et une fraction allant jusqu'à 10 % en poids d'oxyde de titane.

13. Couche calorifuge selon la revendication 12,
**caractérisée en ce que**
l'oxyde d'aluminium et l'oxyde de titane se présentent dans la plage de la couche de finition avec une fraction allant jusqu'à 20 % en poids d'aluminium et une fraction de 5 % en poids d'oxyde de titane.
